# EUROPEAN PATENT SPECIFICATION

(11) **EP 3 550 409 B1**
(45) Date of publication and mention of the grant of the patent: **20.04.2022**
(21) Application number: 17832184.0
(22) Date of filing: 30.06.2017
(51) Int. Cl.: G06F 3/041, G06F 3/044, G01L 1/14, G01L 9/12, G01L 9/08, H01L 27/02, H01L 27/12, H01L 27/32

(54) **ARRAY SUBSTRATE AND MANUFACTURING METHOD THEREFOR, AND DISPLAY PANEL**
ARRAYSUBSTRAT UND HERSTELLUNGSVERFAHREN DAFÜR SOWIE ANZEIGETAFEL
SUBSTRAT DE RÉSEAU ET SON PROCÉDÉ DE FABRICATION ET PANNEAU D'AFFICHAGE

(30) Priority: 01.12.2016 CN 201611090724
(43) Date of publication of application: 09.10.2019
(73) Proprietor: BOE Technology Group Co., Ltd., Beijing 100015 (CN); Ordos Yuansheng Optoelectronics Co., Ltd., Ordos, Inner Mongolia 017020 (CN)
(72) Inventor: GUO, Zhixuan, Beijing 100176 (CN); WANG, Fengguo, Beijing 100176 (CN); WU, Xinguo, Beijing 100176 (CN); LI, Feng, Beijing 100176 (CN); LIU, Hong, Beijing 100176 (CN); WANG, Zifeng, Beijing 100176 (CN); LI, Yuanbo, Beijing 100176 (CN); MA, Bo, Beijing 100176 (CN)
(74) Representative: Klunker IP Patentanwälte PartG mbB
(86) International application number: PCT/CN2017/091106
(87) International publication number: WO 2018/099068

(56) References cited:
- EP-A1- 2 881 785
- CN-A- 105 070 720
- CN-A- 105 136 378
- CN-A- 105 677 111
- CN-A- 105 677 111
- US-A1- 2004 100 612
- US-A1- 2012 242 610
- US-A1- 2013 214 279
- US-A1- 2014 320 766
- US-A1- 2016 276 376

## Description

### TECHNICAL FIELD

The present invention relates to a force sensing display device comprising an array substrate and a manufacturing method thereof.

### BACKGROUND

Force sensing technology refers to a technology by which an external force can be sensed or measured. Many vendors are looking for appropriate technical solutions to enable force sensing in display fields, especially in the field of mobile phones or tablets, so as to enable users to get better and richer human-computer interaction experiences.

CN 105 070 720 A discloses a display panel and a manufacturing method thereof, and a display device comprising the display panel. At least one sensor is integrated into the display panel through a semiconductor process that is at least partially synchronously performed with processes of forming the array substrate and/or color filter substrate of the display panel.

CN 105 677 111 A discloses an array substrate and a display panel. The array substrate includes: a substrate; a plurality of scan lines formed on the substrate and extending along a first direction, a plurality of data lines formed on the substrate and extending along a second direction; a plurality of pixel units is defined by the scan lines and data lines, at least four semiconductor pressure sensing units formed on the substrate. In each of the plurality of the pixel units, a thin film transistor is provided. The substrate is provided with a plurality of connection wires thereon, for connecting the semiconductor pressure sensing units to form at least one Wheatstone bridge structure.

### SUMMARY

It is an object of the present invention to provide a force sensing display device and a corresponding manufacturing method, so as to solve a problem that a via hole between a force electrode wire and a force electrode has a large height to result in a disconnection and poor contact.

The object is achieved by the features of the respective independent claims. Further embodiments are defined in the corresponding dependent claims.

Even though the description refers to embodiments or to the invention, it is to be understood that the invention is defined by the claims and embodiments of the invention are those comprising at least all the features of one of the independent claims.

### BRIEF DESCRIPTION OF THE DRAWINGS

In order to clearly illustrate the technical solution of embodiments of the present disclosure, the drawings of the embodiments will be briefly described in the following, it is obvious that the drawings in the description are only related to some embodiments of the present disclosure and not limited to the present disclosure.
Fig. 1 is a schematic diagram of an array substrate;
Fig. 2 is a sectional view taken along line A-B in Fig. 1;
Fig. 3 is a schematic diagram of an array substrate provided by an embodiment of the present disclosure;
Fig. 4 is a sectional view taken along line C-D in Fig. 3;
Fig. 5 is a schematic diagram illustrating a detection capacitor formed by a force electrode and a middle frame;
Fig. 6 is a schematic diagram illustrating a detection capacitor formed by a force electrode and a middle frame;
Fig. 7 is a schematic diagram illustrating forming a light shielding layer and a force electrode in the same layer on the base substrate (forming a first layer L1);
Fig. 8 is a schematic diagram illustrating forming an active layer of a thin film transistor on a buffer layer;
Fig. 9 is a schematic diagram illustrating forming a via hole running through a gate insulating layer and a buffer layer to facilitate an electrical connection between a force electrodewire and a force electrode; and
Fig. 10 is a schematic diagram illustrating forming a gate electrode and a force electrodewirein the same layeron a gate insulating layer (forming a second layer L2).

### DETAILED DESCRIPTION

In order to make objects, technical details and advantages of the embodiments of the present disclosure apparent, the technical solutions of the embodiments will be described in a clearly and fully understandable way in connection with the drawings related to the embodiments of the present disclosure.It is obvious that the described embodiments are just a part but not all of the embodiments of the present disclosure. Based on the described embodiments herein, a person having ordinary skill in the art may obtain other embodiment(s), without any inventive work, which should be within the scope of the disclosure.

Unless otherwise defined, the technical terms or scientific terms used herein have the same meanings as commonly understood by one of ordinary skill in the art to which the present disclosure belongs. The terms "first," "second," etc., which are used in the present disclosure, are not intended to indicate any sequence, amount or importance, but distinguish various components. Also, the terms such as "a," "an," etc., arc not intended to limit the amount, but indicate the existence of at least one. The terms "comprise," "comprising," "includes," "including," etc., are intended to specify that the elements or the objects stated before these terms encompass the elements or the objects listed after these terms, but do not preclude other elements or objects. The phrases "connect", "connected", etc., are not intended to define a physical connection or mechanical connection, but may include an electrical connection, directly or indirectly. "On," "under," "right," "left" and the like are only used to indicate relative position relationship, and when the position of the object which is described is changed, the relative position relationship may be changed accordingly.

In a thin film transistor liquid crystal display (TFT-LCD) of an in-cell force touch type, a metal of a light shielding (LS) layer is utilized to manufacture a metal mesh sensor as a force electrode, such that a capacitor between the force electrode and a middle frame (for example, a middle frame of a cell-phone) serves as a detection capacitor. A wire of the force electrode adopts a metal of the source drain (SD) layer, and it is needed to form a via hole to connect the force electrode and the wire of the force electrode to transmit a signal.

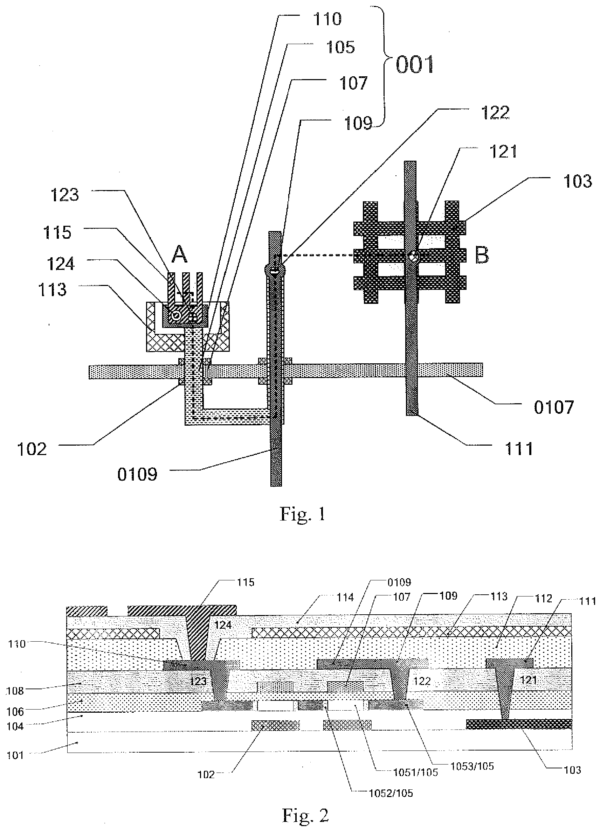

Fig. 1 illustrates an array substrate, and Fig. 2 is a sectional view taken along line A-B in Fig. 1. As illustrated in Fig. 1 and Fig. 2, a force electrode 103 and a light shielding layer 102 are disposed in the same layer; a force electrode wire 111, a source electrode 109, and a drain electrode 110 are disposed in the same layer; the force electrode wire 111 is electrically connected with a force electrode 103 through a via hole 121 running through a buffer layer 104, a gate insulating layer 106 and a interlayer dielectric layer 108.

For example, a thickness of the interlayer dielectric layer 108 can be in a range of 1500 Å-3000 Å, a thickness of the gate insulating layer 106 can be in a range of 400 Å-800 Å, and a thickness of the buffer layer 104 can be in a range of 1000 Å-3000 Å. In order to form a via hole 121 to electrically connect the force electrode wire 111 and the force electrode 103, the interlayer dielectric layer 108, the gate insulating layer 106 and the buffer layer 104 are etched. In the etching process, there is a risk of losing the force electrode 103. Besides, a source electrode 109 and a drain electrode 11 0 are electrically connected with an active layer 105 through via holes 122 and 123 respectively, the via holes 122 and 123 and the via hole 121 can be formed through the same etching process. Upon the via holes 122 and 123 being formed, the interlayer dielectric layer 108, the gate insulating layer 106, the active layer 105, and the buffer layer 104 are etched, so that, there is a risk of damaging the base substrate, and it is hard to control the etching time. Moreover, the via hole (connection hole) of the SD layer and the LS layer and the via hole of the force electrode wire 111 and the force electrode 103 have a large height, which can easily result in defects such as disconnection and poor contact.

Fig. 1 further illustrates a gate line 0107, a gate electrode 107, a data line 0109, a planarization layer 112, a common electrode 113, a passivation layer 114, and a pixel electrode 115, and the pixel electrode 115 is electrically connected with the drain electrode 110 through a via hole 124. Fig. 2 further illustrates an active layer 105 including a channel region 1051, a light doped region 1052, and a heavy doped region 1053. For example, a thickness of the active layer 105 can be in a range of 500±25 Å.

For example, in order to play a better insulation or dielectric function, the interlayer dielectric layer 108, the gate insulating layer 106 or the buffer layer 104 can be adjusted to have a double layer structure. For example, a first sub layer of the interlayer dielectric layer 108 can adopt SiOx, and its thickness can be in a range of 3000±210 Å; a second sub layer of the interlayer dielectric layer 108 can adopt SiNx, and its thickness can be in a range of 2500+175 Å. For example, a first sub layer of the gate insulating layer 106 can adopt SiOx, and its thickness can be in a range of 800±56 Å; a second sub layer of the gate insulating layer 106 can adopt SiNx, and its thickness can be in a range of 400±28 Å. A first sub layer of the buffer layer 104 can adopt SiNx, and its thickness can be in a range of 1000±70 Å, a second sub layer of the buffer layer 104 can adopt SiOx, and its thickness can be in a range of 3000±210 Å.In order to form the via hole 121 to electrically connect the force electrode wire 111 and the force electrode 103, the interlayer dielectric layer 108, the gate insulating layer 106 and the buffer layer 104 are etched, and it is needed to etch a thickness over 10000 Å. In the etching process, there is a risk of losing the force electrode 103. Besides, the source electrode 109 and the drain electrode 110 are electrically connected with the active layer 105 through via holes 122 and 123 respectively, and the via holes 122 and 123 and the via hole 121 can be formed by using the same etching process. Upon the via holes 122 and 123 being formed, the interlayer dielectric layer 108, the gate insulating layer 106, the active layer 105 and the buffer layer 104 are etched, so that, it is needed to etch a thickness over 10000 Å, there is a risk of damaging the base substrate 101, and it is hard to control the etching time. Moreover, the via hole (connection hole) of the SD layer and the LS layer and the via hole of the force electrode wire 111 and the force electrode 103 has a large height, which can easily result in defects such as disconnection and poor contact.

At least one embodiment of the present disclosure provides an array substrate, including:
a base substrate;
a first layer, located on the base substrate, including a force electrode, the force electrode being configured to detect a touch force;
a buffer layer, located on the first layer;
a thin film transistor, including a gate electrode located on the buffer layer;
a second layer, including a force electrode wire and the gate electrode, the force electrode wire and the force electrode are electrically connected.

In the array substrate provided by at least one embodiment of the present disclosure, the force electrode wire and the gate electrode are located in the second layer, in this way, the problem that a via hole between a force electrode wire and a force electrode (a via hole between an SD layer and an LS layer)has a large height to result in a disconnection and poor contact can be solved, and problems, such as damaging the base substrate, losing the force electrode, and hard to control the etching time, during the etching process, can also be solved.

At least one embodiment of the present disclosure provides a manufacturing method of an array substrate, including:
forming a first layer on a base substrate, the first layer including a force electrode, and the force electrode being configured to detect a touch force;
forming a buffer layer on the first layer and a light shielding layer;
forming a gate insulating layer of a thin film transistor on the buffer layer; and
forming a second layer on the gate insulating layer, the second layer including a gate electrode and a force electrode wire,
the force electrode wire and the force electrode being electrically connected.

In the manufacturing method of the array substrate provided by at least one embodiment of the present disclosure, the force electrode wire and the gate electrode are located in the second layer, in this way, the problem that a via hole between a force electrodewire and a force electrode (a via hole between an SD layer and an LS layer) has a large height to result in a disconnection and poor contact can be solved, and problems, such as damaging the base substrate, losing the force electrode, and hard to control the etching time, during the etching process, can also be solved.

Some embodiments will be described in the following.

### First embodiment

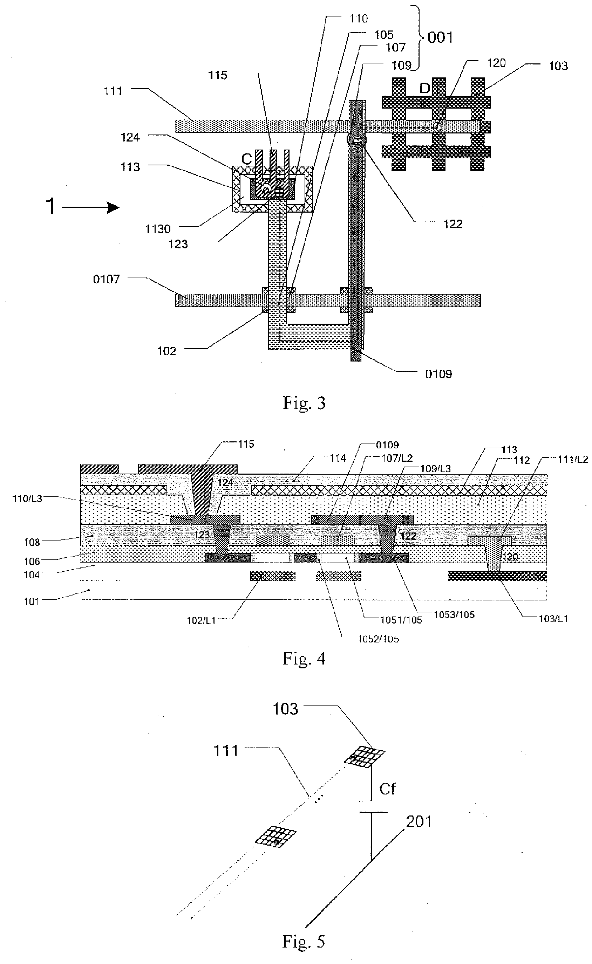

As illustrated in Fig. 3 and Fig. 4, the present embodiment provides an array substrate, the array substrate can be applied to a force sensing device, and the array substrate includes:
a base substrate 101;
a light shielding layer 102, disposed on the base substrate 101;
a force electrode 103, disposed in the same layer with the light shielding layer 102;
a buffer layer 104, disposed on the light shielding layer 102 and the force electrode 103, the force electrode 103 being configured to detect a touch force;
a thin film transistor 001, including an active layer 105, a gate insulating layer 106, and a gate electrode 107 sequentially disposed on the buffer layer 104; and
a force electrode wire 111, disposed in the same layer with the gate electrode 107.

The active layer 105 includes a channel region 1051, the light shielding layer 102 is configured to block light incident on the channel region 1051 of the active layer 105, the force electrode wire 111 and the force electrode 103 are electrically connected. The channel region 1051, for example, refers to a region of the active layer 105 which is overlapped with the gate electrode 107 in a direction perpendicular to the base substrate 101 Fig. 3 is not drawn to scale, and may not illustrate all structures, and only illustrates a structure in which the force electrode wire 111 and the gate electrode 107 are disposed in the same layer. As illustrated in Fig. 3, a gate line 0107 and the gate electrode 107 can be formed in the same layer. For example, the gate line 0107 and the gate electrode 107 are formed integrally. For example, the force electrode wire 111 can be disposed parallel with the gate line 0107. For example, the force electrode wire 111 can be disposed between two adjacent rows of sub pixels, but is not limited thereto. Fig. 3 illustrates one sub pixel 1. One sub pixel, for example, at least includes a thin film transistor and a pixel electrode electrically connected with the thin film transistor, but is not limited thereto.

In the array substrate provided by at least one embodiment of the present disclosure, the force electrode wire 111 and the gate electrode 107 are located in the second layer (located in the same layer), in this way, the problem that a via hole between a force electrode wire and a force electrode (a via hole between an SD layer and an LS layer) has a large height to result in a disconnection and poor contact can be solved, and the problems, such as damaging the base substrate, losing the force electrode, and hard to control the etching time, during the etching process, can also be solved.

For example, the light shielding layer 102 and the force electrode 103 can be located in the first layer L1, for example, formed in the same layer, for example, formed by a metal material, and further for example, formed of molybdenum (Mo), but is not limited thereto. For example, the gate electrode 107 adopts a metal material, and the material of the gate electrode 107, for example, includes any one selected from the group consisting of aluminum, copper, molybdenum, titanium, silver, gold, tantalum, tungsten, chromium, and aluminum alloy, but is not limited thereto. For example, the force electrode wire 111 and the gate electrode 107 are located in the second layer L2. The force electrode wire 111 and the gate electrode 107 are formed of the same material in the same layer, so as to reduce the manufacturing processes. For example, as illustrated in Fig. 3, the force electrode 103 can include a gird formed by a plurality of metal lines. For example, a width of each of the metal lines forming the grid can be in a micrometer level, for example, can be 2-5 micrometers, but is not limited thereto. A size of the force electrode 103 can refer to a common design.

As illustrated in Fig. 3, a data line 0109 can be formed in the same layer with the source electrode 109, but is not limited thereto. The data line 0109 and the source electrode 109 can be formed integrally, but is not limited thereto.

In an example, as illustrated in Fig. 4, the force electrode wire 111 is electrically connected with(lap-jointed to) the force electrode 103 through a via hole 120 formed in the buffer layer 104 and the gate insulating layer 106 to transmit a signal. The via hole 120 can merely (only) run through the gate insulating layer 106 and the buffer layer 104. A height of the via hole 120 in a direction perpendicular to the base substrate 101 can be in a range of 1400 Å -3800 Å. A material of the buffer layer 104 can include silicon nitride (SiNx), silicon oxide (SiOx), or silicon oxynitride (SiNxOy), but is not limited thereto. A thickness of the buffer layer 104 can be in a range of 1000 Å-3000 Å. A material of the gate insulating layer 106 can include silicon nitride (SiNx), silicon oxide (SiOx), or silicon oxynitride (SiNxOy), but is not limited thereto. A thickness of the gate insulating layer 106 can be in a range of 400 Å-800 Å.

In an example, the gate insulating layer 106 and the buffer layer 104 can adopt the above-mentioned double layer structure, so that a height of the via hole 120 in a direction perpendicular to the base substrate 101 can be in a range of 5200±364 Å.

In an example, as illustrated in Fig. 4, the array substrate further includes an interlayer dielectric layer 108, the thin film transistor 001 further includes a source electrode 109 and a drain electrode 110, the interlayer dielectric layer 108 is located between the gate electrode 107, and the source electrode 109 and the drain electrode 110 which are formed in the same layer, the source electrode 109 and the drain electrode 110 are disposed at an interval and electrically connected with the active layer 105 respectively. For example, a material of the interlayer dielectric layer 108 can include silicon nitride (SiNx), silicon oxide (SiOx), or silicon oxynitride (SiNxOy), but is not limited thereto. For example, a thickness of the interlayer dielectric layer 108 can be in a range of 1500 Å-3000 Å.

In an example, the interlayer dielectric layer 108 can adopt the above-mentioned double layer structure, so that a thickness of the interlayer dielectric layer 108 can be in a range of 5500±385 Å.

In an example, as illustrated in Fig. 4, the array substrate further includes a planarization layer 112 disposed on the source electrode 109 and the drain electrode 110, and a common electrode 113 disposed on the planarization layer. A passivation layer 114 is disposed on the common electrode 113, and a pixel electrode 115 is disposed on the passivation layer 114, the pixel electrode 115 is electrically connected with the drain electrode 110. In order to clearly illustrate the other structures, Fig. 3 only illustrates a common electrode 113 near the drain electrode, the common electrode 113 can be a planar electrode and provided with a hollowed structure 1130 in a position where the drain electrode 110 is located, so as to be convenient for the electrical connection of the pixel electrode 115 and the drain electrode 110, so as to make the common electrode 113 insulated (not electrically connected) from the pixel electrode 115. For example, the common electrode 113 can be electrically connected with a common electrode line in a peripheral region to transmit a signal. The peripheral region is located on at least one side of the display region (AA region). For example, the common electrode line can be formed in the same layer with the source electrode 109 and the drain electrode 110, and is electrically connected with the common electrode through a via hole. For example, the planarization layer 112 can adopt an organic resin. For example, a thickness of the planarization layer 112 can be in a range of 23000 Å-28000 Å, but is not limited thereto. For example, a material of the passivation layer 114 can include silicon nitride (SiNx), silicon oxide (SiOx), or silicon oxynitride (SiNxOy), but is not limited thereto. For example, a thickness of the passivation layer 114 can be in a range of 2000 Å-3000 Å, for further example, the thickness of the passivation layer 114 can be in a range of 1000 Å-1500 Å. The array substrate provided by the example can be served as an array substrate of a liquid crystal display panel of an ADS (advanced-super dimensional switching) mode. Generally, a liquid crystal display panel includes an array substrate, an opposing substrate, and a liquid crystal layer sandwiched therebetween. The pixel electrode 115 and the common electrode 113 are configured to apply voltages respectively to form an electric filed to make the liquid crystal in the liquid crystal layer rotate to display. The opposing substrate, for example, can include a color filter substrate, but is not limited thereto.

It is to be noted that, the array substrate provided by the present embodiment can adopt other modes, such as: an HADS (high aperture advanced super dimensional switching) mode, a VA (vertical alignment) mode, a TN (twisted nematic) mode. The structures of the array substrate can be adjusted as required. Besides, the array substrate is not limited to be served as an array substrate of a liquid crystal display panel, but also can be served as an array substrate of an organic light emitting diode display panel.

As illustrated in Fig. 4, the active layer 105 is a semiconductor, for example, a poly-silicon. In addition to the channel region 1051, the active layer 105 can further include a light doped region 1052 and a heavy doped region 1053. It is to be noted that, the material of the active layer 105 is not limited to poly-silicon, but can also adopt other materials, such as amorphous silicon and conductive metal oxide. The structure of the active layer 105 is not limited to that as illustrated in Fig. 4. The active layer 105 can be formed through a common method.

For example, as illustrated in Fig. 4, the thin film transistor 001 can include an active layer 105, a gate insulating layer 106, a gate electrode 107, a source electrode 109, and a drain electrode 110.

### Second embodiment

The present embodiment provides a display panel, including any one of the array substrates provided by the first embodiment, so as to form an in-cell force touch display device.

For example, the display panel includes a liquid crystal display panel or an organic light emitting diode display panel.

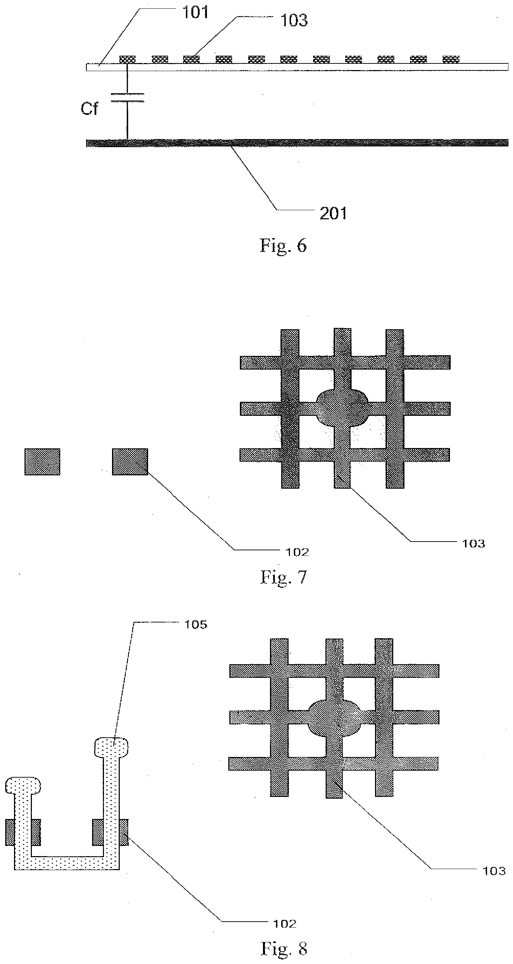

As illustrated in Fig. 5 and Fig. 6, the force electrode 103 and the middle frame 201 form a detection capacitor Cf therebetween. Upon being pressed by a finger, a distance between the force electrode 103 and the middle frame 201 changes, the detection capacitor Cf changes, so as to detect a pressing position and a pressing force of the finger, so as to realize force touch. For example, the middle frame 201 can adopt a metal material. A structure having dielectric performance and located between the force electrode 103 and the middle frame 201 can be served as the dielectric medium of the detection capacitor, and the structure having dielectric performance, for example, includes at least one selected from the group consisting of an air layer, a base substrate, and a film layer. In a case where the display panel is provided with a backlight structure, the backlight structure can be disposed between the middle frame 201 and the array substrate, and a prism sheet and/or a diffuser in the backlight structure can be served as the dielectric medium between the force electrode 103 and the middle frame 201. Fig. 5 only illustrates two force electrodes 103. In Fig. 6, the other structures on the base substrate 101 are omitted.

For example, the display panel provided by the present embodiment can be applied to a display device such as television, digital camera, cell phone, watch, tablet computer, notebook computer, and navigator.

### Third embodiment

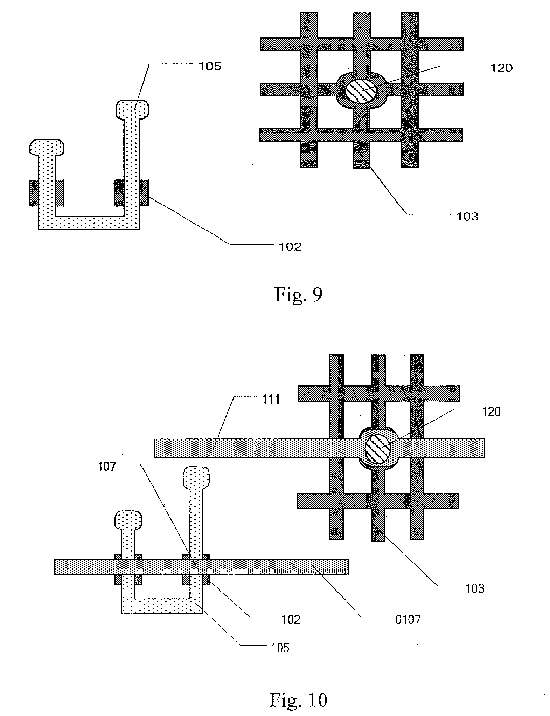

As illustrated in Figs. 3-4 and Figs. 7-10, the present embodiment provides a manufacturing method of an array substrate, including:
as illustrated in Fig. 7, forming a light shielding layer 102 and a force electrode 103 in the same layer on the base substrate 101;
forming a buffer layer 104 on the light shielding layer 102 and the force electrode 103 (as illustrated in Fig. 4);
as illustrated in Fig. 8, forming an active layer 105 of a thin film transistor 001 on the buffer layer 104;
forming a gate insulating layer 106 on the active layer 105 (as illustrated in Fig. 4);
as illustrated in Fig. 4 and Fig. 10, forming a gate electrode 107 and a force electrode wire 111 in the same layer on the gate insulating layer 106.

The active layer 105 includes a channel region 1051, the light shielding layer 102 is configured to block light incident on the channel region 1051 of the active layer 105, and the force electrode wire 111 and the force electrode 103 are electrically connected (as illustrated in Fig. 4).

In the array substrate provided by the present embodiment, the force electrode wire 111 and the gate electrode 107 are located in the same layer, in this way, the problem that a via hole between a force electrode wire and a force electrode (a via hole between an SD layer and an LS layer) has a large height to result in a disconnection and poor contact can be solved, and problems, such as damaging the base substrate, losing the force electrode, and hard to control the etching time, during the etching process, can also be solved.

As illustrated in Fig. 3 and Fig. 4, in an example, a gate line 0107 and the gate electrode 107 can be formed integrally in the same layer. A data line 0109 can be formed integrally in the same layer with the source electrode 109.

In an example, as illustrated in Fig. 9, before forming the gate electrode 107 and the force electrode wire 111 in the same layer on the gate insulating layer 106, the manufacturing method further includes:
forming a via hole 120 running through the gate insulating layer 106 and the buffer layer 104, the force electrode wire 111 is electrically connected with the force electrode 103 through the via hole 120. For example, the via hole 120 only runs through the gate insulating layer 106 and the buffer layer 104. For example, a height of the via hole 120 in a direction perpendicular to the base substrate 101 is in a range of 1400 Å -3800 Å. For example, upon forming a via hole 120, a dry etching process can be adopted.

As illustrated in Fig. 3 and Fig. 4, in an example, after forming the gate insulating layer 106, the method further includes etching the gate insulating layer 106 and the buffer layer 104 to form a via hole 120, then forming a metal layer, and forming the gate electrode 107 and the force electrode wire 111 through a patterning process.

For example, the manufacturing method further includes forming an interlayer dielectric layer 108 on the gate electrode 107 and the force electrode wire 111, and forming a source electrode 109 and a drain electrode 110 on the interlayer dielectric layer 108, the source electrode 109 and the drain electrode 110 are electrically connected with an active layer 105.

The method provided by the present embodiment can form any one of the array substrates provided by the first embodiment. The information about the materials and thickness of the layers can refer to the description in the first embodiment.

It should be understood that, in the embodiments of the present disclosure, "same layer" refers to forming a film layer configured to form a predetermined pattern by the same film forming process, and forming a layer structure with the same mask by one patterning process. According to differences of the predetermined pattern, the one patterning process can include multiple exposures, developments, or etching processes, and the predetermined pattern in the layer structure can be continuous and can be discontinuous, the predetermined pattern can also be in different heights or have different thicknesses.

It is to be noted that, in the embodiments of the present disclosure, the components formed or disposed in the same layer can also be formed respectively, for example, be formed by using different materials and using different patterning processes. For example, the force electrode 103 and the light shielding layer 102 can be formed respectively, and the force electrode wire 111 and the gate electrode 107 can be formed respectively. For example, in the case of being formed respectively, the force electrode 103 and the light shielding layer 102 are disposed on the same film layer and in contact with the film layer. For example, in the case of being formed respectively, the force electrode wire 111 and the gate electrode 107 are disposed on the same film layer and in contact with the film layer.

In the embodiments of the present disclosure, the patterning process can only include a photolithography process, include a photolithography process and an etching process, or include other processes for forming a predetermined pattern such as a printing process and an ink jetting process. The photolithography process refers to a process including a film forming process, an exposure process, and a development process and forming a pattern by using photoresist, a mask plate, and an exposure machine. The patterning process can be selected according to the structures formed in the embodiments of the present disclosure.

In the embodiments of the present disclosure, the force electrode 103 and the light shielding layer 102 can be regarded as a first layer L1, the force electrode wire 111 and the gate electrode 107 can be regarded as a second layer L2, and the source electrode 109 and the drain electrode 110 can be regarded as a third layer L3.

The following statements should be noted:
1) Unless otherwise defined, in the embodiments and accompanying drawings of the present disclosure, the same reference numerals represent the same meaning.
2)The accompanying drawings involve only the structure(s) in connection with the embodiment(s) of the present disclosure, and other structure(s) can be referred to common design(s).
3) For the purpose of clarity only, in accompanying drawings for illustrating the embodiment(s) of the present disclosure, the thickness and size of a layer or a structure may be enlarged. However, it should understood that, in the case in which a component or element such as a layer, film, area, substrate or the like is referred to be "on" or "under" another component or element. it may be directly on or under the another component or element or a component or element is interposed therebetween

## Claims

1. A force sensing display device comprising an array substrate, the array substrate comprising:
a base substrate (101);
a first layer (L1), located on the base substrate (101), comprising a force electrode (103) configured to detect a touch force;
a buffer layer (104), located on the first layer (L1);
a thin film transistor (001), comprising a gate electrode (107) located on the buffer layer (104); and
a second layer (L2), comprising a force electrode wire (111) and the gate electrode (107), wherein the force electrode wire (111) and the force electrode (103) are electrically connected,
a via hole (120), wherein the thin film transistor (001) further comprises a gate insulating layer (106), the gate insulating layer (106) is located on the buffer layer (104), the via hole (120) runs through the buffer layer (104) and the gate insulating layer (106), and the force electrode wire (111) and the force electrode (103) are electrically connected through the via hole (120),
**characterized by**
a middle frame (201), wherein the middle frame (201) and the force electrode (103) are located at two sides of the base substrate (101) that are opposite to each other, respectively,
a dielectric medium provided between the array substrate and the middle frame (201), wherein the force electrode (103) and the middle frame (201) form a detection capacitor (Cf) therebetween, and
the force sensing display device being configured so that upon finger pressure, the distance between the force electrode (103) and the middle frame (201) changes, the detection capacitor (Cf) changes, and touch force is detected.

2. The force sensing display device according to claim 1, wherein the dielectric medium comprises at least one selected from the group consisting of an air layer, a base substrate, and a film layer.

3. The force sensing display device according to claim 1, wherein the via hole (120) only runs through the gate insulating layer (106) and the buffer layer (104).

4. The force sensing display device according to claim 2 or 3, wherein a height of the via hole (120) in a direction perpendicular to the base substrate (101) ranges from about 1400 Å to about 3800 Å; or a height of the via hole (120) in a direction perpendicular to the base substrate (101) is in a range of about 5200±364 Å.

5. The force sensing display device according to any one of claims 1-4, wherein the first layer (L1) further comprises a light shielding layer (102) located on the base substrate (101), the thin film transistor (001) further comprises an active layer (105), the active layer (105) comprises a channel region (1051), the light shielding layer (102) is configured to block light incident on the channel region (1051) of the active layer (105).

6. The force sensing display device according to claim 5, wherein a material of the force electrode (103) is the same as that of the light shielding layer (102), and a material of the force electrode wire (111) is the same as that of the gate electrode (107).

7. The force sensing display device according to any one of claims 1-6, wherein the array substrate further comprises: an interlayer dielectric layer (108); wherein the thin film transistor (001) further comprises a third layer (L3), the third layer (L3) comprises a source electrode (109) and a drain electrode(110);
the interlayer dielectric layer (108) is located between the gate electrode (107) and the third layer (L3); and
the source electrode(109) and the drain electrode(110) are electrically connected with the active layer (105), respectively.

8. The force sensing display device according to claim 7, wherein the array substrate further includes a planarization layer (112) disposed on the source electrode (109) and the drain electrode (110), a common electrode (113) disposed on the planarization layer, a passivation layer (114) disposed on the common electrode (113), and a pixel electrode (115) disposed on the passivation layer (114), the pixel electrode (115) is electrically connected with the drain electrode (110) through a via hole (124) penetrating the planarization layer (112) and the passivation layer (114), the common electrode (113) is a planar electrode and provided with a hollowed structure (1130) in a position where the drain electrode (110) is located, so as to be convenient for an electrical connection of the pixel electrode (115) and the drain electrode (110), so as to make the common electrode (113) insulated from the pixel electrode (115).

9. A manufacturing method of a force sensing display device, comprising: forming an array substrate, wherein forming the array substrate comprises:
forming a first layer (L1) on a base substrate (101), the first layer (L1) comprising a force electrode (103) configured to detect a touch force;
forming a buffer layer (104) on the first layer (L1);
forming a gate insulating layer (106) of a thin film transistor (001) on the buffer layer (104); and
forming a second layer (L2) on the gate insulating layer (106), the second layer (L2) comprising a gate electrode (107) and a force electrode wire (111), wherein the force electrode wire (111) and the force electrode (103) are electrically connected,
before forming the second layer (L2) on the gate insulating layer (106), forming the array substrate further comprises: forming a via hole (120) running through the gate insulating layer (106) and the buffer layer (104), wherein the force electrode wire (111) and the force electrode (103) are electrically connected through the via hole (120), and
**characterized by**
providing a middle frame (201), wherein the middle frame (201) and the force electrode (103) are located at two sides of the base substrate (101) that are opposite to each other, respectively,
providing a dielectric medium between the array substrate and the middle frame, wherein the force electrode (103) and the middle frame (201) form a detection capacitor (Cf) therebetween, and
configuring the force sensing display device so that upon finger pressure, the distance between the force electrode (103) and the middle frame (201) changes, the detection capacitor (Cf) changes, and touch force is detected.

10. The manufacturing method according to claim 9, wherein the force electrode wire (111) and the gate electrode (107) are formed by using a same patterning process, and wherein the first layer (L1) further comprises a light shielding layer (102) located on the base substrate (101), the thin film transistor (001) further comprises an active layer (105), the active layer (105) comprises a channel region (1051), the light shielding layer (102) is configured to block light incident on the channel region (1051) of the active layer (105).

11. The manufacturing method according to claim 10, wherein the force electrode (103) and the light shielding layer (102) are formed by using a same patterning process.

12. The manufacturing method according to any one of claims 9-11, wherein the via hole (120) only runs through the gate insulating layer (106) and the buffer layer (104).

13. The manufacturing method according to any one of claims 9-12, wherein a height of the via hole (120) in a direction perpendicular to the base substrate (101) ranges from about 1400 Å to about 3800 Å; or a height of the via hole (120) in a direction perpendicular to the base substrate (101) is in a range of about 5200±364 Å.

14. The manufacturing method according to any one of claims 9-13, further comprising forming an interlayer dielectric layer (108) on the second layer (L2), and forming a third layer (L3) on the interlayer dielectric layer (108), wherein the third layer (L3) comprises a source electrode (109) and a drain electrode (110), the source electrode (109) and the drain electrode (110) are electrically connected with the active layer (105), respectively.

15. The manufacturing method according to claim 14, wherein forming the array substrate further comprises forming a planarization layer (112) on the source electrode (109) and the drain electrode (110), forming a common electrode (113) on the planarization layer, forming a passivation layer (114) on the common electrode (113), and forming a pixel electrode (115) on the passivation layer (114), wherein the pixel electrode (115) is electrically connected with the drain electrode (110) through a via hole (124) penetrating the planarization layer (112) and the passivation layer (114), and the common electrode (113) is a planar electrode and provided with a hollowed structure (1130) in a position where the drain electrode (110) is located, so as to be convenient for an electrical connection of the pixel electrode (115) and the drain electrode (110), so as to make the common electrode (113) insulated from the pixel electrode (115).

## Patentansprüche

1. Kraftmessende Anzeigevorrichtung, die ein Array-Substrat aufweist, wobei das Array-Substrat aufweist:
ein Basissubstrat (101);
eine erste Schicht (L1), die sich auf dem Basissubstrat (101) befindet und eine Kraftelektrode (103) aufweist, die konfiguriert ist, eine Berührungskraft zu erfassen;
eine Pufferschicht (104), die sich auf der ersten Schicht (L1) befindet;
einen Dünnschichttransistor (001), der eine Gate-Elektrode (107) aufweist, die sich auf der Pufferschicht (104) befindet; und
eine zweite Schicht (L2), die einen Kraftelektrodenleitung (111) und die Gate-Elektrode (107) aufweist, wobei der Kraftelektrodenleitung (111) und die Kraftelektrode (103) elektrisch verbunden sind;
ein Durchgangsloch (120), wobei der Dünnschichttransistor (001) ferner eine Gate-Isolierschicht (106) aufweist, die Gate-Isolierschicht (106) auf der Pufferschicht (104) angeordnet ist, das Durchgangsloch (120) durch die Pufferschicht (104) und die Gate-Isolierschicht (106) verläuft und die Kraftelektrodenleitung (111) und die Kraftelektrode (103) durch das Durchgangsloch (120) elektrisch verbunden sind,
**gekennzeichnet durch**
einen mittleren Rahmen (201), wobei der mittlere Rahmen (201) und die Kraftelektrode (103) an zwei Seiten des Basissubstrats (101) angeordnet sind, die jeweils einander gegenüberliegen,
ein dielektrisches Medium, das zwischen dem Array-Substrat und dem mittleren Rahmen (201) vorgesehen ist, wobei die Kraftelektrode (103) und der mittlere Rahmen (201) einen Detektionskondensator (Cf) dazwischen bilden, und
die Krafterfassungsvorrichtung konfiguriert ist, dass sich bei Fingerdruck den Abstand zwischen der Kraftelektrode (103) und dem mittleren Rahmen (201) ändert, der Erfassungskondensator (Cf) sich ändert und die Berührungskraft erfasst wird.

2. Kraftmessende Anzeigevorrichtung nach Anspruch 1, wobei das dielektrische Medium mindestens eines aufweist, das aus der Gruppe ausgewählt ist, die besteht aus einer Luftschicht, einem Basissubstrat und einer Filmschicht.

3. Kraftmessende Anzeigevorrichtung nach Anspruch 1, wobei das Durchgangsloch (120) nur durch die Gate-Isolierschicht (106) und die Pufferschicht (104) verläuft.

4. Kraftmessende Anzeigevorrichtung nach Anspruch 2 oder 3, wobei eine Höhe des Durchgangslochs (120) in einer Richtung senkrecht zu dem Basissubstrat (101) im Bereich von etwa 1400 Å bis etwa 3800 Å liegt; oder eine Höhe des Durchgangslochs (120) in einer Richtung senkrecht zu dem Basissubstrat (101) in einem Bereich von etwa 5200±364 Å liegt.

5. Kraftmessende Anzeigevorrichtung nach einem der Ansprüche 1-4, wobei die erste Schicht (L1) ferner eine auf dem Basissubstrat (101) angeordnete Lichtabschirmungsschicht (102) aufweist, der Dünnschichttransistor (001) ferner eine aktive Schicht (105) aufweist, die aktive Schicht (105) einen Kanalbereich (1051) aufweist, die Lichtabschirmungsschicht (102) konfiguriert ist, auf den Kanalbereich (1051) der aktiven Schicht (105) einfallendes Licht zu blockieren.

6. Kraftmessende Anzeigevorrichtung nach Anspruch 5, wobei ein Material der Kraftelektrode (103) dasselbe ist wie das der Lichtabschirmungsschicht (102) und ein Material der Kraftelektrodenleitung (111) dasselbe ist wie das der Gate-Elektrode (107).

7. Kraftmessende Anzeigevorrichtung nach einem der Ansprüche 1-6, wobei das Array-Substrat weiterhin aufweist: eine dielektrische Zwischenschicht (108); wobei der Dünnschichttransistor (001) weiterhin eine dritte Schicht (L3) aufweist, wobei die dritte Schicht (L3) eine Source-Elektrode (109) und eine Drain-Elektrode (110) aufweist;
wobei die dielektrische Zwischenschicht (108) sich zwischen der Gate-Elektrode (107) und der dritten Schicht (L3) befindet; und
wobei die Source-Elektrode (109) und die Drain-Elektrode (110) jeweils mit der aktiven Schicht (105) elektrisch verbunden sind.

8. Kraftmessende Anzeigevorrichtung nach Anspruch 7, wobei das Array-Substrat ferner aufweist eine Planarisierungsschicht (112), die auf der Source-Elektrode (109) und der Drain-Elektrode (110) angeordnet ist, eine gemeinsame Elektrode (113), die auf der Planarisierungsschicht angeordnet ist, eine Passivierungsschicht (114), die auf der gemeinsamen Elektrode (113) angeordnet ist, und eine Pixelelektrode (115), die auf der Passivierungsschicht (114) angeordnet ist, wobei die Pixelelektrode (115) mit der Drain-Elektrode (110) durch ein Durchgangsloch (124), das die Planarisierungsschicht (112) und die Passivierungsschicht (114) durchdringt, elektrisch verbunden ist, die gemeinsame Elektrode (113) eine Planarelektrode ist und an einer Position, an der sich die Drain-Elektrode (110) befindet, mit einer ausgehöhlten Struktur (1130) versehen ist, sodass sie für eine elektrische Verbindung der Pixelelektrode (115) und der Drain-Elektrode (110) geeignet ist, sodass die gemeinsame Elektrode (113) von der Pixelelektrode (115) isoliert ist.

9. Herstellungsverfahren für eine kraftmessende Anzeigevorrichtung, aufweisend: Bilden eines Array-Substrats, wobei das Bilden des Array-Substrats aufweist:
Bilden einer ersten Schicht (L1) auf einem Basissubstrat (101), wobei die erste Schicht (L1) eine Kraftelektrode (103) aufweist, die zum Erfassen einer Berührungskraft konfiguriert ist;
Bilden einer Pufferschicht (104) auf der ersten Schicht (L1);
Bilden einer Gate-Isolierschicht (106) eines Dünnschichttransistors (001) auf der Pufferschicht (104); und
Bilden einer zweiten Schicht (L2) auf der Gate-Isolierschicht (106), wobei die zweite Schicht (L2) eine Gate-Elektrode (107) und eine Kraftelektrodenleitung (111) aufweist, wobei die Kraftelektrodenleitung (111) und die Kraftelektrode (103) elektrisch verbunden sind,
vor dem Bilden der zweiten Schicht (L2) auf der Gate-Isolierschicht (106), das Bilden des Array-Substrats weiterhin aufweisend: Bilden eines Durchgangslochs (120), das durch die Gate-Isolierschicht (106) und die Pufferschicht (104) verläuft, wobei die Kraftelektrodenleitung (111) und die Kraftelektrode (103) durch das Durchgangsloch (120) elektrisch verbunden sind, und
**gekennzeichnet durch**
Bereitstellen eines mittleren Rahmens (201), wobei der mittlere Rahmen (201) und die Kraftelektrode (103) an zwei Seiten des Basissubstrats (101) angeordnet sind, die jeweils einander gegenüberliegen,
Bereitstellen eines dielektrischen Mediums zwischen dem Array-Substrat und dem mittleren Rahmen, wobei die Kraftelektrode (103) und der mittlere Rahmen (201) einen Detektionskondensator (Cf) dazwischen bilden, und
Konfigurieren der kraftmessenden Anzeigevorrichtung, sodass sich bei Fingerdruck der Abstand zwischen der Kraftelektrode (103) und dem mittleren Rahmen (201) ändert, der Erfassungskondensator (Cf) sich ändert und die Berührungskraft erfasst wird.

10. Herstellungsverfahren nach Anspruch 9, wobei der Kraftelektrodendraht (111) und die Gate-Elektrode (107) unter Verwendung desselben Strukturierungsprozesses gebildet werden, und wobei die erste Schicht (L1) ferner eine Lichtabschirmungsschicht (102) aufweist, die sich auf dem Basissubstrat (101) befindet, der Dünnschichttransistor (001) ferner eine aktive Schicht (105) aufweist, die aktive Schicht (105) einen Kanalbereich (1051) aufweist, die Lichtabschirmungsschicht (102) konfiguriert ist, dass sie auf den Kanalbereich (1051) der aktiven Schicht (105) einfallendes Licht blockiert.

11. Herstellungsverfahren nach Anspruch 10, wobei die Kraftelektrode (103) und die Lichtabschirmungsschicht (102) unter Verwendung desselben Strukturierungsprozesses gebildet werden.

12. Herstellungsverfahren nach einem der Ansprüche 9-11, wobei das Durchgangsloch (120) nur durch die Gate-Isolierschicht (106) und die Pufferschicht (104) verläuft.

13. Herstellungsverfahren nach einem der Ansprüche 9-12, wobei eine Höhe des Durchgangslochs (120) in einer Richtung senkrecht zum Basissubstrat (101) im Bereich von etwa 1400 Å bis etwa 3800 Å liegt; oder eine Höhe des Durchgangslochs (120) in einer Richtung senkrecht zum Basissubstrat (101) in einem Bereich von etwa 5200±364 Å liegt.

14. Herstellungsverfahren nach einem der Ansprüche 9-13, ferner aufweisend das Bilden einer dielektrischen Zwischenschicht (108) auf der zweiten Schicht (L2) und das Bilden einer dritten Schicht (L3) auf der dielektrischen Zwischenschicht (108), wobei die dritte Schicht (L3) eine Source-Elektrode (109) und eine Drain-Elektrode (110) aufweist, wobei die Source-Elektrode (109) und die Drain-Elektrode (110) jeweils mit der aktiven Schicht (105) elektrisch verbunden sind.

15. Herstellungsverfahren nach Anspruch 14, wobei das Bilden des Array-Substrats ferner das Bilden einer Planarisierungsschicht (112) auf der Source-Elektrode (109) und der Drain-Elektrode (110), das Bilden einer gemeinsamen Elektrode (113) auf der Planarisierungsschicht, das Bilden einer Passivierungsschicht (114) auf der gemeinsamen Elektrode (113) und das Bilden einer Pixelelektrode (115) auf der Passivierungsschicht (114) aufweist, wobei die Pixelelektrode (115) mit der Drain-Elektrode (110) durch ein Durchgangsloch (124), das die Planarisierungsschicht (112) und die Passivierungsschicht (114) durchdringt, elektrisch verbunden ist, und die gemeinsame Elektrode (113) eine Planarelektrode ist und an einer Position, an der sich die Drain-Elektrode (110) befindet, mit einer ausgehöhlten Struktur (1130) versehen ist, sodass sie für eine elektrische Verbindung der Pixelelektrode (115) und der Drain-Elektrode (110) geeignet ist, um die gemeinsame Elektrode (113) von der Pixelelektrode (115) zu isolieren.

## Revendications

1. Dispositif d'affichage à détection de force comprenant un substrat de réseau, le substrat de réseau comprenant :
un substrat de base (101) ;
une première couche (L1), localisée sur le substrat de base (101), qui comprend une électrode de force (103) qui est configurée pour détecter une force de contact tactile ;
une couche tampon (104), localisée sur la première couche (L1) ;
un transistor à film mince (001), qui comprend une électrode de grille (107) qui est localisée sur la couche tampon (104) ;
une deuxième couche (L2), qui comprend un fil d'électrode de force (111) et l'électrode de grille (107), dans lequel le fil d'électrode de force (111) et l'électrode de force (103) sont connectés électriquement ; et
un trou de via (120), dans lequel le transistor à film mince (001) comprend en outre une couche d'isolation de grille (106), la couche d'isolation de grille (106) est localisée sur la couche tampon (104), le trou de via (120) chemine au travers de la couche tampon (104) et de la couche d'isolation de grille (106), et le fil d'électrode de force (111) et l'électrode de force (103) sont connectés électriquement au travers du trou de via (120) ;
**caractérisé par** :
une structure intermédiaire (201), dans lequel la structure intermédiaire (201) et l'électrode de force (103) sont respectivement localisées au niveau de deux côtés du substrat de base (101) qui sont opposés l'un à l'autre ; et
un milieu diélectrique qui est prévu entre le substrat de réseau et la structure intermédiaire (201) ;
dans lequel l'électrode de force (103) et la structure intermédiaire (201) forment un condensateur de détection (Cf) entre elles ; et
le dispositif d'affichage à détection de force étant configuré de telle sorte que, suite à l'exercice d'une pression par un doigt, la distance entre l'électrode de force (103) et la structure intermédiaire (201) soit modifiée, le condensateur de détection (Cf) soit modifié et la force de contact tactile soit détectée.

2. Dispositif d'affichage à détection de force selon la revendication 1, dans lequel le milieu diélectrique comprend au moins un milieu qui est sélectionné parmi le groupe qui est constitué par une couche d'air, un substrat de base et une couche sous forme de film.

3. Dispositif d'affichage à détection de force selon la revendication 1, dans lequel le trou de via (120) chemine seulement au travers de la couche d'isolation de grille (106) et de la couche tampon (104).

4. Dispositif d'affichage à détection de force selon la revendication 2 ou 3, dans lequel une hauteur du trou de via (120) dans une direction qui est perpendiculaire au substrat de base (101) s'inscrit à l'intérieur d'une plage qui va d'environ 1400 Å à environ 3800 Å ; ou une hauteur du trou de via (120) dans une direction qui est perpendiculaire au substrat de base (101) s'inscrit à l'intérieur d'une plage d'environ 5200 ± 364 Å.

5. Dispositif d'affichage à détection de force selon l'une quelconque des revendications 1 à 4, dans lequel la première couche (L1) comprend en outre une couche de protection vis-à-vis de la lumière (102) qui est localisée sur le substrat de base (101), le transistor à film mince (001) comprend en outre une couche active (105), la couche active (105) comprend une région de canal (1051), et la couche de protection vis-à-vis de la lumière (102) est configurée pour bloquer la lumière qui arrive en incidence sur la région de canal (1051) de la couche active (105).

6. Dispositif d'affichage à détection de force selon la revendication 5, dans lequel un matériau de l'électrode de force (103) est le même que celui de la couche de protection vis-à-vis de la lumière (102), et un matériau du fil d'électrode de force (111) est le même que celui de l'électrode de grille (107).

7. Dispositif d'affichage à détection de force selon l'une quelconque des revendications 1 à 6, dans lequel le substrat de réseau comprend en outre une couche diélectrique inter-couche (108) ; dans lequel le transistor à film mince (001) comprend en outre une troisième couche (L3), la troisième couche (L3) comprend une électrode de source (109) et une électrode de drain (110) ;
la couche diélectrique inter-couche (108) est localisée entre l'électrode de grille (107) et la troisième couche (L3) ; et
l'électrode de source (109) et l'électrode de drain (110) sont respectivement connectées électriquement à la couche active (105).

8. Dispositif d'affichage à détection de force selon la revendication 7, dans lequel le substrat de réseau inclut en outre une couche de planarisation (112) qui est disposée sur l'électrode de source (109) et l'électrode de drain (110), une électrode commune (113) qui est disposée sur la couche de planarisation, une couche de passivation (114) qui est disposée sur l'électrode commune (113) et une électrode de pixel (115) qui est disposée sur la couche de passivation (114), l'électrode de pixel (115) est connectée électriquement à l'électrode de drain (110) au travers d'un trou de via (124) qui pénètre la couche de planarisation (112) et la couche de passivation (114), l'électrode commune (113) est une électrode plane et elle est munie d'une structure creuse (1130) au niveau d'une position au niveau de laquelle l'électrode de drain (110) est localisée, de manière à permettre une connexion électrique de l'électrode de pixel (115) et de l'électrode de drain (110), de manière à faire en sorte que l'électrode commune (113) soit isolée de l'électrode de pixel (115).

9. Procédé de fabrication d'un dispositif d'affichage à détection de force, comprenant : la formation d'un substrat de réseau, dans lequel la formation du substrat de réseau comprend :
la formation d'une première couche (L1) sur un substrat de base (101), la première couche (L1) comprenant une électrode de force (103) qui est configurée pour détecter une force de contact tactile ;
la formation d'une couche tampon (104) sur la première couche (L1) ;
la formation d'une couche d'isolation de grille (106) d'un transistor à film mince (001) sur la couche tampon (104) ;
la formation d'une deuxième couche (L2) sur la couche d'isolation de grille (106), la deuxième couche (L2) comprenant une électrode de grille (107) et un fil d'électrode de force (111), dans lequel le fil d'électrode de force (111) et l'électrode de force (103) sont connectés électriquement ; et
avant la formation de la deuxième couche (L2) sur la couche d'isolation de grille (106), la formation du substrat de réseau comprend en outre : la formation d'un trou de via (120) qui chemine au travers de la couche d'isolation de grille (106) et de la couche tampon (104), dans lequel le fil d'électrode de force (111) et l'électrode de force (103) sont connectés électriquement au travers du trou de via (120) ; et
**caractérisé par** :
la constitution d'une structure intermédiaire (201), dans lequel la structure intermédiaire (201) et l'électrode de force (103) sont respectivement localisées au niveau de deux côtés du substrat de base (101) qui sont opposés l'un à l'autre ;
la constitution d'un milieu diélectrique entre le substrat de réseau et la structure intermédiaire, dans lequel l'électrode de force (103) et la structure intermédiaire (201) forment un condensateur de détection (Cf) entre elles ; et
la configuration du dispositif d'affichage à détection de force de telle sorte que, suite à l'exercice d'une pression par un doigt, la distance entre l'électrode de force (103) et la structure intermédiaire (201) soit modifiée, le condensateur de détection (Cf) soit modifié et la force de contact tactile soit détectée.

10. Procédé de fabrication selon la revendication 9, dans lequel le fil d'électrode de force (111) et l'électrode de grille (107) sont formés en utilisant un même processus de formation de motif(s), et dans lequel la première couche (L1) comprend en outre une couche de protection vis-à-vis de la lumière (102) qui est localisée sur le substrat de base (101), le transistor à film mince (001) comprend en outre une couche active (105), la couche active (105) comprend une région de canal (1051), et la couche de protection vis-à-vis de la lumière (102) est configurée pour bloquer la lumière qui arrive en incidence sur la région de canal (1051) de la couche active (105).

11. Procédé de fabrication selon la revendication 10, dans lequel l'électrode de force (103) et la couche de protection vis-à-vis de la lumière (102) sont formées en utilisant un même processus de formation de motif(s).

12. Procédé de fabrication selon l'une quelconque des revendications 9 à 11, dans lequel le trou de via (120) chemine seulement au travers de la couche d'isolation de grille (106) et de la couche tampon (104).

13. Procédé de fabrication selon l'une quelconque des revendications 9 à 12, dans lequel une hauteur du trou de via (120) dans une direction qui est perpendiculaire au substrat de base (101) s'inscrit à l'intérieur d'une plage qui va d'environ 1400 Å à environ 3800 Å ; ou une hauteur du trou de via (120) dans une direction qui est perpendiculaire au substrat de base (101) s'inscrit à l'intérieur d'une plage d'environ 5200 ± 364 Å.

14. Procédé de fabrication selon l'une quelconque des revendications 9 à 13, comprenant en outre la formation d'une couche diélectrique inter-couche (108) sur la deuxième couche (L2), et la formation d'une troisième couche (L3) sur la couche diélectrique inter-couche (108), dans lequel la troisième couche (L3) comprend une électrode de source (109) et une électrode de drain (110), et l'électrode de source (109) et l'électrode de drain (110) sont respectivement connectées électriquement à la couche active (105).

15. Procédé de fabrication selon la revendication 14, dans lequel la formation du substrat de réseau comprend en outre la formation d'une couche de planarisation (112) sur l'électrode de source (109) et l'électrode de drain (110), la formation d'une électrode commune (113) sur la couche de planarisation, la formation d'une couche de passivation (114) sur l'électrode commune (113) et la formation d'une électrode de pixel (115) sur la couche de passivation (114), dans lequel l'électrode de pixel (115) est connectée électriquement à l'électrode de drain (110) au travers d'un trou de via (124) qui pénètre la couche de planarisation (112) et la couche de passivation (114), et l'électrode commune (113) est une électrode plane et elle est munie d'une structure creuse (1130) au niveau d'une position au niveau de laquelle l'électrode de drain (110) est localisée, de manière à permettre une connexion électrique de l'électrode de pixel (115) et de l'électrode de drain (110), de manière à faire en sorte que l'électrode commune (113) soit isolée de l'électrode de pixel (115).
